# EUROPEAN PATENT SPECIFICATION

(11) **EP 1 717 789 B1**
(45) Date of publication and mention of the grant of the patent: **13.04.2016**
(21) Application number: 06007905.0
(22) Date of filing: 13.04.2006
(51) Int. Cl.: G09G 3/32, H01L 27/32

(54) **Electro luminescence display device**
Elektrolumineszenzanzeigevorrichtung
Dispositif d'affichage à électroluminescence

(30) Priority: 26.04.2005 KR 20050034752; 05.07.2005 KR 20050060495
(43) Date of publication of application: 02.11.2006
(73) Proprietor: LG Display Co., Ltd., Seoul 150-721 (KR)
(72) Inventor: Kim, Woochan, Gangdong-gu Seoul (KR); Yoon, Jong Geun, Anyang-si Gyeonggi-do (KR)
(74) Representative: Viering, Jentschura & Partner mbB Patent- und Rechtsanwälte

(56) References cited:
- EP-A- 1 503 422
- US-A- 6 066 916
- US-A1- 2003 030 381
- US-A1- 2003 222 589
- US-A1- 2004 256 620

## Description

### BACKGROUND OF THE INVENTION

### Field of the Invention

The present invention generally relates to electro luminescence (hereinafter, EL) display devices.

### Description of the Related Art

An organic EL display device, which utilizes an organic electro luminescent element to emit light by recombination of electrons and holes, has a shorter response time than a passive type display device such as a liquid crystal display (hereinafter, LCD) that requires a separate light source. Furthermore, since an organic EL display device can be driven by low voltage direct current and be manufactured as a thin film, it can be applied to a wall-type display or a portable display.

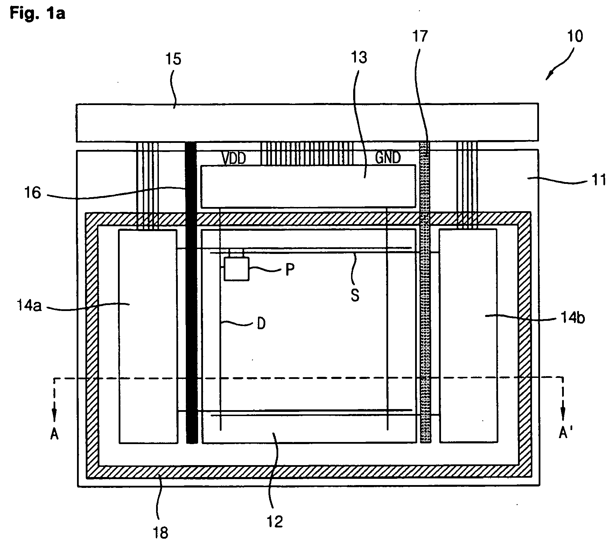

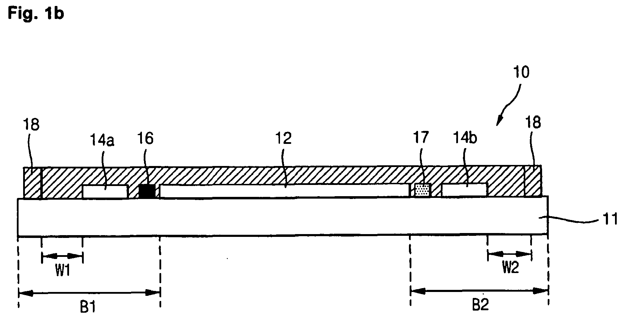

Fig. 1a is a plane view showing internal construction of a conventional organic EL display device and Fig. 1b is a cross-sectional view along line A-A' of Fig. 1a. For convenience of explanation, Figs. 1a and 1b have been illustrated without a protective plate over the display device.

The organic EL display device 10 comprises a pixel circuit 12, which is installed on a substrate 11 and displays images, while a plurality of RGB pixels P is formed within the pixel circuit 12. For convenience of explanation, Fig. 1a illustrates only one pixel.

A data driver 13 connected to data line D of each pixel P, is formed at an outer side of the pixel circuit 12 corresponding to an outer circuit 15, and enables data signals to be transmitted to pixels Ps.

A first scan driver 14a connected to scan lines S of some pixels is located at one side of the pixel circuit 12, while a second driver 14b connected to scan lines S of the other pixels is located at the other side of pixel circuit 12, and enables scan signals to be transmitted to pixels Ps. As the first driver 14a and the second driver 14b are connected electrically to the outer circuit 15, the pixels P can be driven by electrical signals from the outer circuit 15.

Outer surfaces of the pixel circuit 12, of data driver 13, of first scan driver 14a, and of second scan driver 14b, are treated with sealant 18 to allow a protective plate be attached on the substrate 11, so that all the components including pixels Ps can be isolated from the outside and be protected from impurities such as humidity, oxygen, etc.

A power supply line (hereinafter, VDD) 16 is located on the substrate 11 between the first scan driver 14a and the pixel circuit 12, and a ground line (hereinafter, GND) 17 is located on the substrate 11 between the second scan driver 14b and the pixel circuit 12, whereby the VDD 16 and the GND 17 are connected to the outer circuit 15.

Referring to Figs. 1a and 1b, the areas between vertical hemlines of the pixel circuit 12 and terminals of the substrate 11 are called Bezel areas B1 and B2. The Bezel areas B1, B2, in which no image can be displayed, function as a factor for enlarging the size of an organic EL display device. In a conventional organic EL display device, a display device with a bigger Bezel area needs to be larger-sized than one with a smaller Bezel area, even when the two display devices have a same-sized pixel circuit. In this case, sizes of the main window and the sub-window of a mobile communication terminal adopting such an organic EL display device need to be bigger as well. Moreover, the Bezel areas create, in the main window and in the sub-window of the mobile communication terminal, a considerable size of dead spaces where no image can be displayed.

Although the protective plate on the display device has been omitted in the above drawings for the convenience of this discussion, in the conventional art, one W1 of curing margins are provided between sealants 18 and the first scan driver 14a. Simultaneously, the other W2 of curing margins are provided between sealants 18 and the first scan driver 14b.

These curing margins W1 and W2 protect the scan drivers 14a and 14b from unexpected damage when the protective plate is adhered on the substrate by sealant 18 in the process of optical and/or heat curing. For example, a positioning error can occur due to various factors in the course of optical curing after a prescribed thickness of the sealant 18 has been sprayed on the substrate 11. A positioning error allows UV rays to cause damage to the first scan driver 14a and the second scan driver 14b. Also, when main circuits such as scan drivers 14a and 14b are damaged, noise can be generated in the circuit.

Accordingly, when the size of the curing margins increase, the size of the Bezel areas increases resulting in a decreasing probability of an error. However, increasing curing margins also increases the number of dead spaces where no images can be displayed.

### SUMMARY OF THE INVENTION

Accordingly, the present invention is to solve at least the problems and disadvantages of the related art.

Thus, the present invention provides an electro luminescence display device according to claim 1 and further provides an electro luminescence display device according to claim 3. Further embodiments of the invention are described in the dependent claims.

The aspect of the present invention is to provide electro luminescence display devices that can minimize the Bezel area through effective alignment of components thereof.

### BRIEF DESCRIPTION OF THE DRAWINGS

The invention will be described in detail with reference to the following drawings in which like numerals refer to like elements.
Fig. 1a is a plane view showing internal construction of a conventional organic
   EL display device.
Fig. 1b is a cross-sectional view along line A-A'of Fig. 1a.
Fig. 2a is a plane view showing internal construction of an organic EL display device in accordance with a first embodiment example of the present invention.
Fig. 2b is a cross-sectional view along line Z-Z' of Fig. 2a.
Fig. 3 is a plane view showing internal construction of an organic EL display device in accordance with a second embodiment example of the present invention.
Fig. 4 is a plane view showing internal construction of an organic EL display device in accordance with a first comparative example of the present invention.
Fig. 5 is a plane view showing internal construction of an organic EL display device in accordance with a second comparative example of the present invention.
Fig. 6 is a plane view showing internal construction of an organic EL display device in accordance with a third comparative example of the present invention.

### DETAILED DESCRIPTION OF PREFERRED EMBODIMENTS

Preferred embodiments of the present invention and comparative examples will be described in a more detailed manner with reference to the drawings.

### First Embodiment

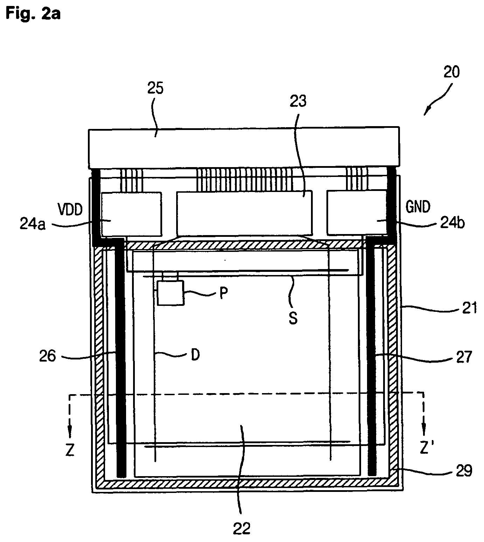

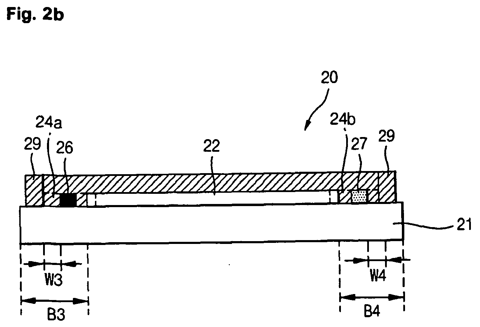

Fig. 2a is a plane view showing internal construction of an organic EL display device in accordance with a first embodiment example of the present invention, and Fig. 2b is a cross-sectional view along line Z-Z' of Fig. 2a.

As shown in the drawings, an EL display device 20 as per the first embodiment of the present invention comprises an pixel circuit 22 formed on a substrate 21 for displaying images, whereby the pixel circuit 22 includes a plurality of RGB pixels. In addition, a data driver 23 connected to data lines D of the pixels P is formed at one side of the pixel circuit 22, i.e. at an area adjacent to an outer circuit 25 for supplying data signals to the pixels P.

Adjacent to the pixel circuit 22, a first scan driver 24a connected to scan line S of the pixels P is formed at one side of the data driver 23, and a second scan driver 24b connected to scan line S of the pixels P is formed at the other side of the data driver 23, whereby the data driver 23, the first scan driver 24a, and the second scan driver 24b are electrically connected to the outer circuit 25. As a result, the pixels P can be driven by the first and the second scan drivers 24a, 24b upon receiving signals from the outer circuit 25.

Power lines connected to the outer circuit 25, i.e. a power supply line 26 and a ground line 27 are installed at outer side of the first scan driver 24a and of the second scan driver 24b from the pixel circuit 22, respectively. There is a sealant 29 on the fringe of them which seals the pixel circuit 22 from impurities such as water and oxygen.

However, the above allocation of the power supply line 26 and the ground line 27 is only an example from an embodiment of the present invention. The locations of the power supply line 26 and the ground line 27 can vary dependant on the designs. Here, it is important that the power supply line 26 and the ground line 27 are placed at outer sides of the first and the second scan drivers 26, 27. As a result, provision of curing margins W3, W4 becomes minimized or unnecessary, as the first and the second scan drivers 24a, 24b are placed sufficiently inwardly and are protected from ultra violet rays.

By installing the first scan driver 24a and the second scan driver 24b at both sides of the data driver 23 as shown in Figs. 2a and 2b, and not at both sides of the pixel circuit 22 as in Fig.1, the Bezel areas B1, B2 formed between terminals of the substrate 21 and terminals of the pixel circuit 22 can substantially be reduced.

Accordingly, a compact EL display device with a minimal size of Bezel area can be manufactured by optimizing positions of the data driver and the scan drivers.

Other embodiments of the present invention and comparative examples, of which a description follows below, have been generated by varying positions of the components, wherein like numerals refer to like elements. In the following description, only an explanation on positional differences of the components with direct relevancy to the present invention such as the first scan driver, the second scan driver, the power supply line (hereinafter, VDD), and the ground line (hereinafter, GND) is given, and explanation on functions of such components as well as explanation on other components are omitted.

### Second Embodiment

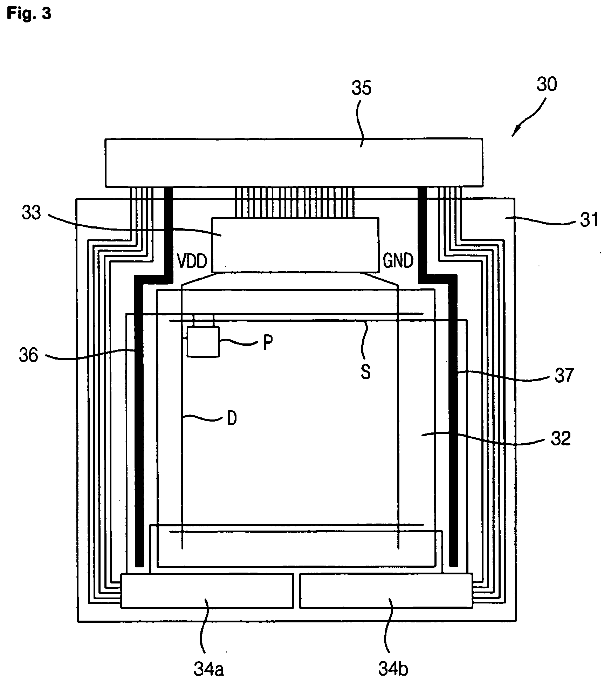

Fig. 3 is a plane view showing internal construction of an organic EL display device in accordance with a second embodiment example of the present invention.

As a preliminary, the drawings of the second embodiment of the present invention show a display device in a state the protective plate has been removed and depict the components in a schematic manner. Accordingly, sealant to be applied on outer sides of the pixel circuit 32, the data driver 33, the first scan driver 34a, and the second scan driver 34b, as well as a protective plate to be affixed on the substrate 31 by sealant are not illustrated.

As shown in Fig. 3, positions of the first scan driver 34a and of the second scan driver 34b on the organic EL display device 30, as they are on a non-emitting area, differ from the forming positions of the first scan driver 24a and the second scan driver 24b in Fig, 2a.

As the first scan driver 34a and the second scan driver 34b are located on each side of the pixel circuit 32 on the opposite side of the data driver 33, so the size of Bezel areas formed by spaces between both ends of the pixel circuit 32 and of the substrate 31 are reduced substantially.

### First Comparative Example

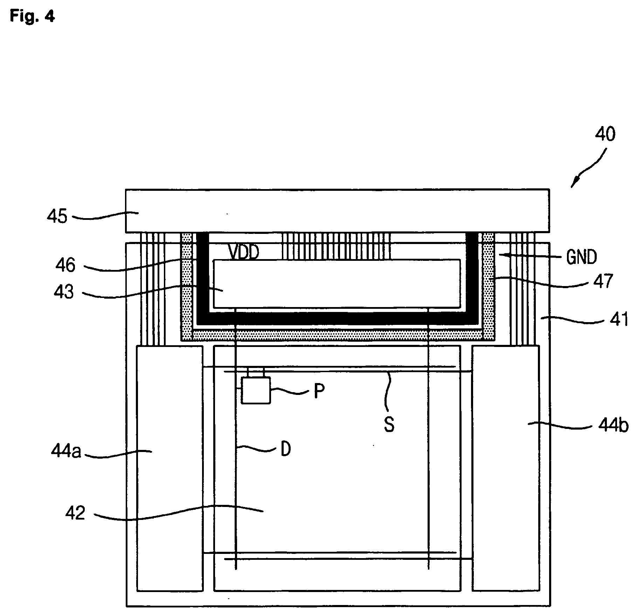

Fig. 4 is a plane view showing internal construction of an organic EL display device in accordance with a first comparative example.

As a preliminary, the drawings of the first comparative example show a display device in a state the protecting plate has been removed and depict the components in a schematic manner. Accordingly, sealant to be applied on outer sides of the pixel circuit 42, the data driver 43, the first scan driver 44a, and the second scan driver 44b, as well as a protective plate to be affixed on the substrate 41 by sealant are not illustrated.

As shown in Fig. 4, a data driver 43 is formed at one side of the pixel circuit 42, while a first scan driver 44a and a second scan driver 44b are formed at other sides of the pixel circuit 42, respectively, on an organic EL display device 40.

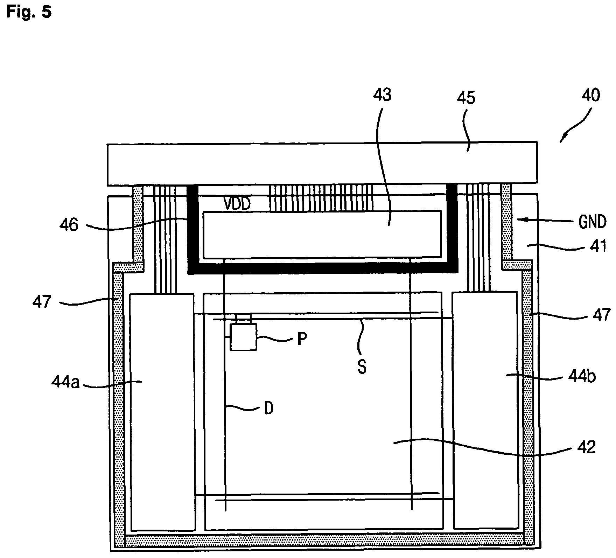

Both a VDD 46 and a GND 47 are formed between the data driver 43 and the pixel circuit 42 along rim of the data driver 43 as shown in Fig. 5. By not installing the VDD 46 and the GND 47 at both sides of the pixel circuit 42, the size of Bezel areas are reduced substantially.

### Second Comparative Example

Fig. 5 is a plane view showing internal construction of an organic EL display device in accordance with a second comparative example.

As shown in Fig. 5, arrangements of the pixel circuit 42, data driver 43, the first scan driver 44a, and the second scan driver 44b on the organic EL display device 40 are the same as in the second embodiment example.

A VDD 4 6 is formed between the data driver 43 and the pixel circuit 42, and a GND 47 is formed along outer rim of the substrate 41 as shown in Fig. 5. By not installing the VDD 46 and the GND 47 at both sides of the pixel circuit 42, the size of Bezel areas are reduced substantially.

### Third Comparative Example

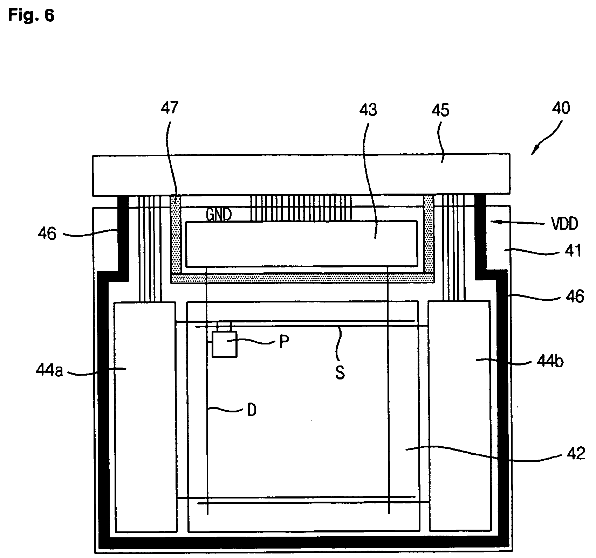

Fig. 6 is a plane view showing internal construction of an organic EL display device in accordance with a third comparative example.

As a preliminary, the drawings of third comparative example show a display device in a state the protecting plate has been removed and depict the components in a schematic manner. Accordingly, sealant to be applied on outer sides of the pixel circuit 42, the data driver 43, the first scan driver 44a, and the second scan driver 44b, as well as a protective plate to be affixed on the substrate 41 by sealant are not illustrated.

As shown in Fig. 6, a GND 47 is formed between the data driver 43 and the pixel circuit 42, and a VDD 46 is formed along outer rim of the substrate 41as shown in Fig. 5. By not installing the VDD 46 and the GND 47 at both sides of the pixel circuit 42, the size of Bezel areas are reduced substantially.

Although the above embodiments of the present invention and comparative examples have been described to comprise one data driver each, the present invention is not limited thereto, but rather can adopt a plurality of data driver as well.

## Claims

1. An electro luminescence display device comprising:
a pixel circuit (22) comprising a plurality of pixels (P) on a substrate;
an outer circuit (25) located outside the substrate at an upper side of the pixel circuit (22);
a data driver (23) formed on the substrate and formed at the upper side of the pixel circuit (22) between the pixel circuit (22) and the outer circuit (25) for supplying a data signal to the plurality of pixels;
first and second scan drivers (24a, 24b) formed on the substrate and formed at the upper side of the pixel circuit (22) between the pixel circuit (22) and the outer circuit (25) for supplying a scan signal to the plurality of pixels; wherein the data driver (23) is located between the first and second scan drivers (24a, 24b) along the direction of the upper side of the pixel circuit (22); and
a ground line GND (27) and a power supply line VDD (26) both of which are formed on the substrate and are connected to the outer circuit (25), wherein the ground line GND (27) and the power supply line VDD (26) are separated from each other, so that the power supply line VDD (26) is placed at outer left side and a portion of outer left lower side of the first scan driver (24a), and outer left side of the pixel circuit (22), and so that the ground line GND (27) is placed at outer right side and a portion of outer right lower side of the second scan driver (24b), and outer right side of the pixel circuit (22), wherein the right and left sides of the pixel circuit (22) are perpendicular to the upper side of the pixel circuit (22), wherein the pixel circuit (22), the data driver (23) and the first and second scan drivers (24a, 24b) are located between the ground line GND (27) and the power supply line VDD (26).

2. The electro luminescence display device as set forth in claim 1, wherein the pixel circuit (22) of the electro luminescence display device comprises an organic luminescence layer.

3. An electro luminescence display device comprising:
a pixel circuit (32) comprising a plurality of pixels (P) on a substrate ;
an outer circuit (35) located outside the substrate at an upper side of the pixel circuit (32);
a data driver (33) formed on the substrate and formed at the upper side of the pixel circuit (32) between the pixel circuit (32) and the outer circuit (35) for supplying a data signal to the plurality of pixels;
first and second scan drivers (34a, 34b) formed on the substrate and formed side by side along a lower side of the pixel circuit (32) opposite the upper side of the pixel circuit (32), and for supplying a scan signal to the plurality of pixels; and
a ground line GND (37) and a power line VDD (36) both of which are formed on the substrate and are connected to the outer circuit (35), wherein the ground line GND (37) and the power supply line VDD (36) are separated from each other, so that the power supply line VDD (36) is placed at outer left side of the data driver (33), and at outer left side and a portion of outer left upper side of the pixel circuit (32), and so that the ground line GND (37) is placed at outer right side of the data driver (33), and at outer right side and a portion of outer right upper side of the pixel circuit (32), wherein the right and left sides of the pixel circuit (32) are perpendicular to the upper and lower sides of the pixel circuit (32), wherein each of the pixel circuit (32) and the data driver (33) extends between the ground line GND (37) and the power supply line VDD (36).

4. The electro luminescence display device as set forth in claim 3, wherein the pixel circuit of the electro luminescence display device comprises an organic luminescence layer.

## Patentansprüche

1. Elektrolumineszenz-Anzeigevorrichtung, aufweisend:
einen Pixel-Schaltkreis (22), der eine Mehrzahl von Pixeln (P) auf einem Substrat aufweist;
einen äußeren Schaltkreis (25), der außerhalb des Substrats an einer oberen Seite des Pixel-Schaltkreises (22) angeordnet ist;
einen Datentreiber (23), der auf dem Substrat gebildet ist und der an der oberen Seite des Pixel-Schaltkreises (22) zwischen dem Pixel-Schaltkreis (22) und dem äußeren Schaltkreis (25) zum Zuführen eines Datensignals zu der Mehrzahl von Pixeln angeordnet ist;
einen ersten Abtast-Treiber (24a) und einen zweiten Abtast-Treiber (24b), die auf dem Substrat gebildet sind und die an der oberen Seite des Pixel-Schaltkreises (22) zwischen dem Pixel-Schaltkreis (22) und dem äußeren Schaltkreis (25) zum Zuführen eines Abtastsignals zu der Mehrzahl von Pixeln angeordnet sind; wobei der Datentreiber (23) zwischen dem ersten Abtast-Treiber (24a) und dem zweiten Abtast-Treiber (24b) entlang der Richtung der oberen Seite des Pixel-Schaltkreises (22) angeordnet ist; und
eine Erdungsleitung GND (27) und eine Stromzuführungsleitung VDD (26), die beide auf dem Substrat gebildet sind und die mit dem äußeren Schaltkreis (25) verbunden sind, wobei die Erdungsleitung GND (27) und die Stromzuführungsleitung VDD (26) getrennt voneinander angeordnet sind, so dass die Stromzuführungsleitung VDD (26) an einer äußeren linken Seite und einem Bereich der äußeren linken unteren Seite des ersten Abtast-Treibers (24a) und einer äußeren linken Seite des Pixel-Schaltkreises (22) angeordnet ist, und so dass die Erdungsleitung GND (27) an einer äußeren rechten Seite und einem Bereich einer äußeren rechten unteren Seite des zweiten Abtast-Treibers (24b) und einer äußeren rechten Seite des Pixel-Schaltkreises (22) angeordnet ist, wobei die rechte Seite und die linke Seite des Pixel-Schaltkreises (22) senkrecht zu der oberen Seite des Pixel-Schaltkreises (22) sind, wobei der Pixel-Schaltkreis (22), der Datentreiber (23) und der erste Abtast-Treiber (24a) und der zweite Abtast-Treiber (24b) zwischen der Erdungsleitung GND (27) und der Stromzuführungsleitung VDD (26) angeordnet sind.

2. Elektrolumineszenz-Anzeigevorrichtung gemäß Anspruch 1, wobei der Pixel-Schaltkreis (22) der Elektrolumineszenz-Anzeigevorrichtung eine organische Lumineszenz-Schicht aufweist.

3. Elektrolumineszenz-Anzeigevorrichtung, aufweisend:
einen Pixel-Schaltkreis (32), der eine Mehrzahl von Pixeln (P) auf einem Substrat aufweist;
einen äußeren Schaltkreis (35), der außerhalb des Substrats an einer oberen Seite des Pixel-Schaltkreises (32) angeordnet ist;
einen Datentreiber (33), der auf dem Substrat gebildet ist und der an der oberen Seite des Pixel-Schaltkreises (32) zwischen dem Pixel-Schaltkreis (32) und dem äußeren Schaltkreis (35) zum Zuführen eines Datensignals zu der Mehrzahl von Pixeln angeordnet ist;
einen ersten Abtast-Treiber (34a) und einen zweiten Abtast-Treiber (34b), die auf dem Substrat gebildet sind und die nebeneinander entlang einer unteren Seite des Pixel-Schaltkreises (32) gegenüber der oberen Seite des Pixel-Schaltkreises (32) gebildet sind, und zum Zuführen eines Abtastsignals zu der Mehrzahl von Pixeln; und
eine Erdungsleitung GND (37) und eine Stromzuführungsleitung VDD (36), die beide auf dem Substrat gebildet sind und die mit dem äußeren Schaltkreis (35) verbunden sind, wobei die Erdungsleitung GND (37) und die Stromzuführungsleitung VDD (36) getrennt voneinander angeordnet sind, so dass die Stromzuführungsleitung VDD (36) an einer äußeren linken Seite des Datentreibers (33) und an einer äußeren linken Seite und einem Bereich einer äußeren linken oberen Seite des Pixel-Schaltkreises (32) angeordnet ist, und so dass die Erdungsleitung GND (37) an einer äußeren rechten Seite des Datentreibers (33) und an einer äußeren rechten Seite und einem Bereich einer äußeren rechten oberen Seite des Pixel-Schaltkreises (32) angeordnet ist, wobei die rechte Seite und die linke Seite des Pixel-Schaltkreises (32) senkrecht zu der oberen Seite und der unteren Seite des Pixel-Schaltkreises (32) sind, wobei sich sowohl der Pixel-Schaltkreis (32) als auch der Datentreiber (33) zwischen der Erdungsleitung GND (37) und der Stromzuführungsleitung VDD (36) erstrecken.

4. Elektrolumineszenz-Anzeigevorrichtung gemäß Anspruch 3, wobei der Pixel-Schaltkreis der Elektrolumineszenz-Anzeigevorrichtung eine organische Lumineszenz-Schicht aufweist.

## Revendications

1. Dispositif d'affichage à électroluminescence qui comprend :
- un circuit à pixels (22) qui comprend une pluralité de pixels (P) sur un substrat ;
- un circuit externe (25) qui se trouve à l'extérieur du substrat, au niveau d'un côté supérieur du circuit à pixels (22) ;
- un lecteur de données (23) formé sur le substrat et formé au niveau du côté supérieur du circuit à pixels (22), entre le circuit à pixels (22) et le circuit externe (25), afin de fournir un signal de données à la pluralité de pixels ;
- un premier et un second lecteurs de scans (24a, 24b) formés sur le substrat et formés au niveau du côté supérieur du circuit à pixels (22), entre le circuit à pixels (22) et le circuit externe (25), afin de fournir un signal de scan à la pluralité de pixels ; dans lequel le lecteur de données (23) se trouve entre le premier et le second lecteurs de scans (24a, 24b) dans la direction du côté supérieur du circuit à pixels (22) ; et
- une ligne de terre GND (27) et une ligne d'alimentation VDD (26) qui sont formées sur le substrat et qui sont reliées au circuit externe (25), la ligne de terre GND (27) et la ligne d'alimentation VDD (26) étant séparées l'une de l'autre, de sorte que la ligne d'alimentation VDD (26) soit placée au niveau du côté extérieur gauche et d'une partie du côté inférieur gauche extérieur du premier lecteur de scans (24a), et au niveau du côté extérieur gauche du circuit à pixels (22), et de sorte que la ligne de terre GND (27) soit placée au niveau du côté extérieur droit et d'une partie du côté inférieur droit extérieur du second lecteur de scans (24b), et au niveau du côté extérieur droit du circuit à pixels (22), les côtés gauche et droit du circuit à pixels (22) étant perpendiculaires au côté supérieur du circuit à pixels (22), le circuit à pixels (22), le lecteur de données (23) et le premier et le second lecteurs de scans (24a, 24b) étant situés entre la ligne de terre GND (27) et la ligne d'alimentation VDD (26).

2. Dispositif d'affichage à électroluminescence selon la revendication 1, dans lequel le circuit à pixels (22) du dispositif d'affichage à électroluminescence comprend une couche de luminescence organique.

3. Dispositif d'affichage à électroluminescence qui comprend :
- un circuit à pixels (32) qui comprend une pluralité de pixels (P) sur un substrat ;
- un circuit externe (35) qui se trouve à l'extérieur du substrat, au niveau d'un côté supérieur du circuit à pixels (32) ;
- un lecteur de données (33) formé sur le substrat et formé au niveau du côté supérieur du circuit à pixels (32), entre le circuit à pixels (32) et le circuit externe (35), afin de fournir un signal de données à la pluralité de pixels ;
- un premier et un second lecteurs de scans (34a, 34b) formés sur le substrat et formés cote à cote le long d'un côté inférieur du circuit à pixels (32) opposé au côté supérieur du circuit à pixels (32), et destinés à fournir un signal de scan à la pluralité de pixels ; et
- une ligne de terre GND (37) et une ligne d'alimentation VDD (36) qui sont formées sur le substrat et qui sont reliées au circuit externe (35), la ligne de terre GND (37) et la ligne d'alimentation VDD (36) étant séparées l'une de l'autre, de sorte que la ligne d'alimentation VDD (36) soit placée au niveau du côté extérieur gauche du lecteur de données (33), et au niveau du côté extérieur gauche et d'une partie du côté supérieur gauche externe du circuit à pixels (32), et de sorte que la ligne de terre GND (37) soit placée au niveau du côté extérieur droit du lecteur de données (33), et au niveau du côté extérieur droit et d'une partie du côté supérieur droit externe du circuit à pixels (32), les côtés gauche et droit du circuit à pixels (32) étant perpendiculaires aux côtés supérieur et inférieur du circuit à pixels (32), chacun du circuit à pixels (32) et du lecteur de données (33) s'étendant entre la ligne de terre GND (37) et la ligne d'alimentation VDD (36).

4. Dispositif d'affichage à électroluminescence selon la revendication 3, dans lequel le circuit à pixels du dispositif d'affichage à électroluminescence comprend une couche de luminescence organique.
